# EUROPEAN PATENT APPLICATION

(11) **EP 2 677 545 A1**
(43) Date of publication of application: **25.12.2013**
(21) Application number: 12173194.7
(22) Date of filing: 22.06.2012
(51) Int. Cl.: H01L 31/0216, H01L 27/144, H01L 27/146, H01L 31/18

(54) **Method of producing a photodiode with improved responsivity**

(71) Applicant: ams AG, 8141 Unterpremstätten (AT)
(72) Inventor: Jonak-Auer, Ingrid, 8043 Graz (AT); Jessenig, Stefan, 8010 Graz (AT); Schmiderer, Arnold, 8453 St. Johann (AT)
(74) Representative: Epping - Hermann - Fischer

(57) **Abstract**

The method comprises the steps of providing a substrate (1) of a semiconductor material with a doped region (2) forming a photodiode (3), arranging an antireflective layer (5) and a top layer (6) above the photodiode, and etching a trench (8) in the top layer, so that the trench uncovers the antireflective layer at least partially. The top layer (6) is etched selectively with respect to the antireflective layer (5). The antireflective layer (5) can thus be provided with a defined thickness, which is very precisely maintained for an optimization of the responsivity.

## Description

The responsivity, the ratio of a generated photocurrent to incident light power, expressed in the unit A/W, and the external quantum efficiency, the ratio of the number of photogenerated electron-hole pairs to the number of incident photons, are important characteristics of a photodetector. Consequently various concepts have already been conceived to improve the responsivity of photodiodes.

WO 2004/021452 A2 discloses integrated photosensitive structures and a passivation method, in which one individual layer is arranged on the photosensitive area as the last applied layer of a passivation layer system. The layer has an optical thickness for high transmission to reduce losses due to light reflection.

US 7,545,016 B2 discloses an integrated layer stack arrangement, an optical sensor and a method for producing an integrated layer stack arrangement including a plurality of layer stacks. A trench is arranged above a photodiode and extends at least through a portion of the layer stacks. A first partial passivation layer is applied on the layer stacks, and a second partial passivation layer is applied on the layer stacks and on a bottom and walls of the trench.

An object of the invention is to provide a novel method of producing a photodiode that facilitates an optimization of the responsivity or external quantum efficiency.

This object is achieved with the method according to claim 1. Variants derive from the dependent claims.

The method comprises the steps of providing a substrate of a semiconductor material, which may be silicon, for example, with a doped region forming a photodiode, arranging an antireflective layer above the photodiode, applying a top layer covering the antireflective layer and etching a trench in the top layer above the photodiode, so that the trench uncovers the antireflective layer or at least a surface area of the antireflective layer that is intended for the incidence of radiation to be detected.

In variants of the method the substrate is silicon, and the antireflective layer is formed from a material having an index of refraction between 1.4 and 2.2, particularly from SiO₂ or from Si₃N₄.

In a further variant the trench is formed by etching the top layer selectively with respect to the antireflective layer.

In a further variant an etch stop layer is arranged on the antireflective layer, the top layer is applied on the etch stop layer, and the trench is formed by etching the top layer selectively with respect to the etch stop layer. The etch stop layer may be TiN, for instance.

In a further variant the etch stop layer is removed after the trench is etched, and the etch stop layer is removed selectively with respect to the antireflective layer.

In a further variant a dielectric layer, which may be an oxide of the semiconductor material of the substrate, is applied between the substrate and the antireflective layer.

In a further variant the antireflective layer is structured by photolithography and an etching step, in which the dielectric layer serves as an etch stop. The antireflective layer is preferably formed from a material that is selectively etchable with respect to the dielectric layer.

The following is a detailed description of examples of the invention in conjunction with the accompanying drawings.
Figure 1 shows a cross-section of an intermediate product of an example of the method.
Figure 2 shows a cross-section according to Figure 1 after the application of a top layer.
Figure 3 shows a cross-section according to Figure 2 after the etching of a trench.
Figure 4 shows a cross-section according to Figure 1 for a variant of the method using an etch stop layer.
Figure 5 shows a cross-section according to Figure 4 after the application of a top layer.
Figure 6 shows a cross-section according to Figure 5 after the etching of a trench.
Figure 7 shows a cross-section according to Figures 1 or 4 for a variant of the method using a further etch stop layer.
Figure 8 shows a cross-section according to Figure 7 after the application of a top layer.
Figure 9 shows a cross-section according to Figure 8 after the etching of a trench.

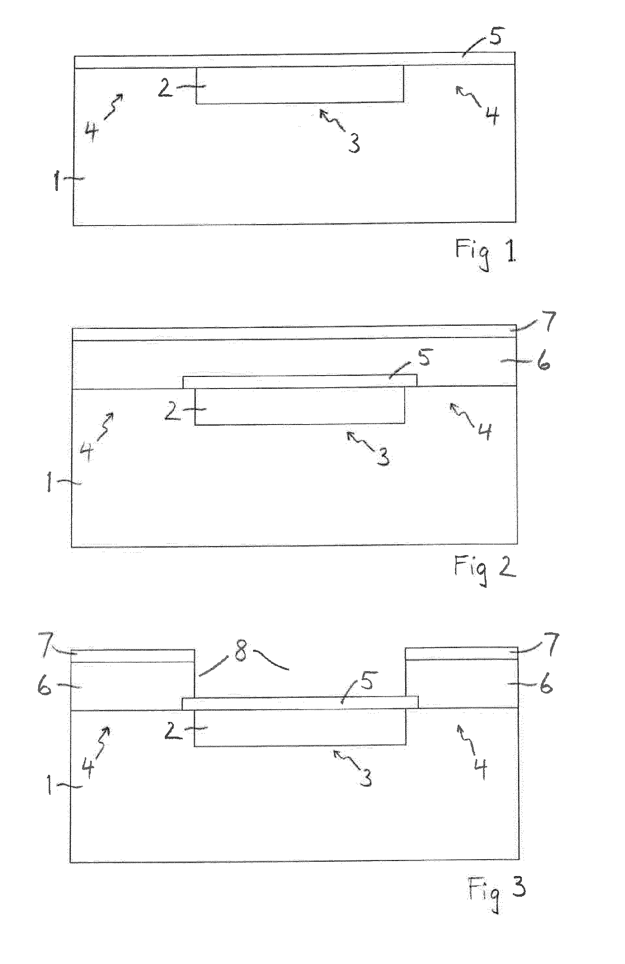

Figure 1 shows a cross-section of a semiconductor substrate 1, which may be silicon, for example. The substrate 1 comprises a doped region 2 that is provided for a photodiode 3 and forms a pn junction with adjacent semiconductor material of the opposite type of conductivity. The structure of the photodiode 3 is not essential for the invention, which can be applied with any type of photodiodes, and is therefore only represented schematically in the figures. The further substrate regions 4 indicated in the figures may be provided with electronic devices or integrated circuits like CMOS circuits, for example.

An antireflective layer 5 is applied to the surface of the substrate 1 at least in an area covering the photodiode 3. The antireflective layer 5 is provided to minimize the reflected or absorbed fraction of the optical power of incident radiation in order to optimize the external quantum efficiency for a target wavelength or a desired range of wavelengths. An especially suitable value of the thickness of the antireflective layer 5 is ¼ λ/n(λ), where λ is a selected wavelength and n(λ) is the index of refraction of the antireflective layer 5 at this wavelength. The material of the antireflective layer 5 is preferably selected to have an index of refraction that is in the range between 1 and the index of refraction of the semiconductor material. An especially suitable value of the index of refraction n(λ) of the antireflective layer 5 is n (λ) = (n_{sc}(λ)nₛ(λ))^{½}, where n_{sc}(λ) is the index of refraction of the substrate 1 adjacent to the antireflective layer 5, and nₛ(λ) is the index of refraction on the opposite side of the antireflective layer 5; if there is environmental air, nₛ(λ) ≈ 1, for instance. If the substrate 1 is silicon, it may be favourable to select the material of the antireflective layer 5 to have an index of refraction n (λ) with 1.4<n(λ) < 2.2. In this case the antireflective layer 5 may be SiO₂ with n(λ) ≈ 1.45 or Si₃N₄ with n(λ) ≈ 2.0, for example.

Figure 2 shows a cross-section according to Figure 1 after the application of a top layer 6, which may be a layer stack comprising a wiring for integrated circuits or the like and may especially comprise conductor tracks in metal layers, connecting vias, and intermetal dielectric. Such a top layer 6 may be typically 7 µm to 10 µm thick, for example. A passivation layer 7 may be applied on the top layer 6 in the way known per se from semiconductor devices. The passivation layer 7 may be silicon nitride, for example. As the layers 6, 7 reduce the fraction of incident radiation that reaches the photodiode 3, the passivation layer 7 and the top layer 6 are removed from above the photodiode 3.

Figure 3 shows a cross-section according to Figure 2 after the etching of a trench 8 in the passivation layer 7 and the top layer 6 above the photodiode 3. The etching may be effected by plasma etching, for example. The trench 8 uncovers the antireflective layer 5 or at least a surface area of the antireflective layer 5 that is intended for the incidence of radiation to be detected. At the end of the etching process it is favourable if the antireflective layer 5 serves as an etch stop layer. For this purpose the materials of the antireflective layer 5 and the top layer 6 are preferably selected so that the top layer 6 can be etched selectively with respect to the antireflective layer 5. Thus the defined thickness of the antireflective layer 5 can precisely be maintained, and the photodiode 3 is protected from the etch attack.

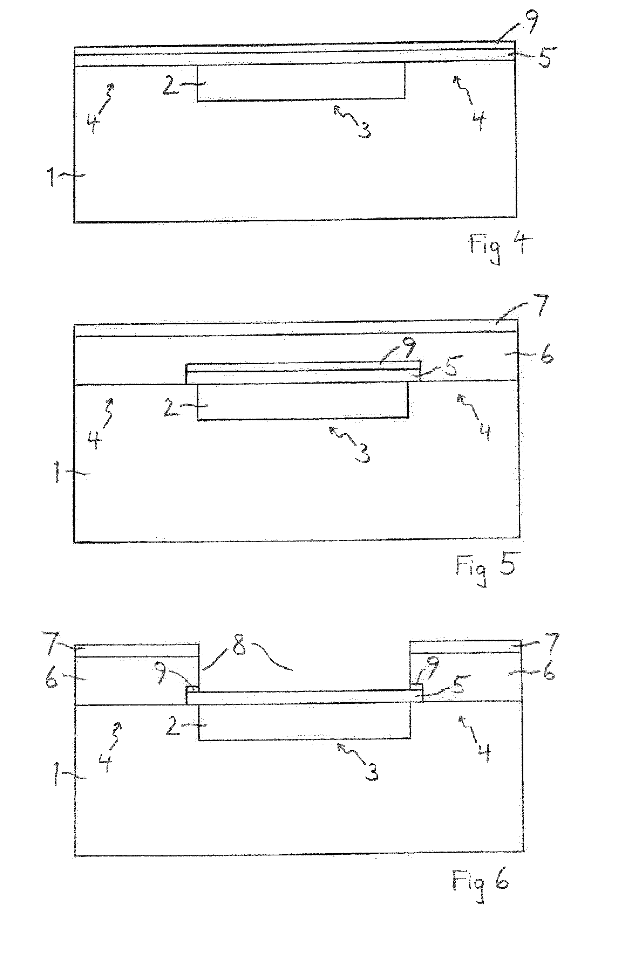

Figure 4 shows a cross-section according to Figure 1 for a variant of the method in which an etch stop layer 9, which may be TiN, for instance, is applied on the antireflective layer 5. The etch stop layer 9 is preferably structured together with the antireflective layer 5.

According to Figure 5, a top layer 6 and a passivation layer 7 may be applied as in the preceding embodiment according to Figure 2.

Figure 6 shows the cross-section according to Figure 5 after the etching of the trench 8. At the end of the etching process the etch stop layer 9 protects the antireflective layer 5 and allows the original thickness of the antireflective layer 5 to be preserved. The etch stop layer 9 may then be removed with high selectivity to the antireflective layer 5, for instance by a wet etching step. As the antireflective layer 5 is thus scarcely affected by the etching, the desired properties of the antireflective layer 5 can easily be obtained.

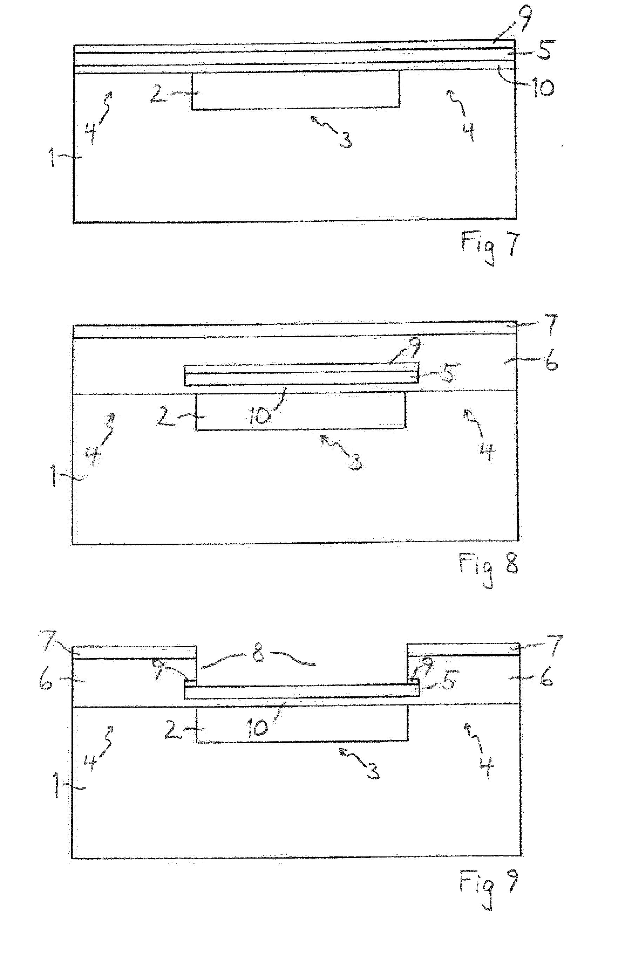

Figure 7 shows a cross-section according to Figure 4 for a variant of the method in which a dielectric layer 10 is arranged between the substrate 1 and the antireflective layer 5. This can be achieved by a surface oxidation of the substrate 1 before the antireflective layer 5 is applied.

Instead, a thin oxide layer may be deposited on the substrate surface. The purpose of the dielectric layer 10 is to protect the semiconductor surface of the substrate 1 in lateral areas outside the area of the photodiode 3 during the structuring of the antireflective layer 5. A protection of the substrate surface is achieved with the dielectric layer 10 independently of the presence of an etch stop layer 9. In the embodiment according to Figure 7, an etch stop layer 9 is applied on the antireflective layer 5 as in the preceding embodiment according to Figures 4 to 6. The dielectric layer 10 can also be used in embodiments that do not comprise such an etch stop layer 9.

According to Figure 8, a top layer 6 and a passivation layer 7 may be applied as in the preceding embodiments according to Figures 2 and 5. Figure 8 does not show a limit between the dielectric layer 10 and the top layer 6 to indicate that the dielectric layer 10 and the top layer 6 may both comprise the same dielectric, which may be an oxide of the semiconductor material, for example.

Figure 9 shows the cross-section according to Figure 8 after the etching of the trench 8. The etch stop layer 9 may be provided to stop the etching process, so that the antireflective layer 5 is not affected. The etch stop layer 9 may then be removed very selectively with respect to the antireflective layer 5 to preserve its original thickness, and the optimization of essential properties of the antireflective layer 5 is thus facilitated as in the preceding embodiment according to Figures 4 to 7. The dielectric layer 10 is preferably made sufficiently thin to have only a minor influence on the transmissive properties of the antireflective layer 5, and the index of refraction of the dielectric layer 10 can be taken account of to optimize the antireflective layer 5.

The invention can be applied to all photodiode layouts. The photodiode can be integrated with components of a circuit by using method steps of a standard production process. A substantially higher responsivity of the photodiode is achieved while narrow production tolerances can be obeyed. The thickness of the antireflective layer is very precisely controlled and is independent of the dimensions of the trench that opens the area of incidence of radiation. This area is passivated by the antireflective layer, so that no further passivation layer, which would reduce the external quantum efficiency, is required.

### List of reference numerals

- 1: substrate
- 2: doped region
- 3: photodiode
- 4: further substrate region
- 5: antireflective layer
- 6: top layer
- 7: passivation layer
- 8: trench
- 9: etch stop layer
- 10: dielectric layer

## Claims

1. A method of producing a photodiode, comprising:
- providing a substrate (1) of a semiconductor material with a doped region (2) forming a photodiode (3),
- arranging an antireflective layer (5) above the photodiode (3),
- applying a top layer (6) covering the antireflective layer (5), and
- etching a trench (8) in the top layer (5) above the photodiode (3), the trench (8) uncovering a surface area of the antireflective layer (5).

2. The method of claim 1 wherein
the substrate (1) is silicon and
the antireflective layer (5) is formed from SiO₂ or from Si₃N₄.

3. The method of claim 1 wherein
the substrate (1) is silicon and
the antireflective layer (5) is formed from a material having an index of refraction between 1.4 and 2.2.

4. The method of one of claims 1 to 3, wherein
the trench (8) is formed by etching the top layer (6) selectively with respect to the antireflective layer (5).

5. The method of one of claims 1 to 3, further comprising:
- an etch stop layer (9) being arranged on the antireflective layer (5),
- the top layer (6) being arranged on the etch stop layer (9), and
- the trench (8) being formed by etching the top layer (6) selectively with respect to the etch stop layer (9).

6. The method of claim 5, wherein
the etch stop layer (9) is TiN.

7. The method of claim 5 or 6, wherein
after the etching of the trench (8) the etch stop layer (9) is selectively removed with respect to the antireflective layer (5).

8. The method of one of claims 1 to 7, further comprising:
applying a dielectric layer (10) between the substrate (1) and the antireflective layer (5).

9. The method of claim 8, wherein
the antireflective layer (5) is structured by an etching step, in which the dielectric layer (10) serves as an etch stop.

10. The method of claim 8 or 9, wherein
the dielectric layer (10) is an oxide of the semiconductor material of the substrate (1), and
the antireflective layer (5) is formed from a material that is selectively etchable with respect to the dielectric layer (10).
